# FASCICULE DE BREVET EUROPEEN

(11) **EP 2 072 458 B1**
(45) Date de publication et mention de la délivrance du brevet: **01.10.2014**
(21) Numéro de dépôt: 08172462.7
(22) Date de dépôt: 19.12.2008
(51) Int. Cl.: B82Y 10/00, H01L 21/768, H01L 23/532, H01L 29/41

(54) **Procédé de formation de catalyseur de croissance de nanotubes/nanofibres et de croissance horizontale de nanotubes/nanofibres**
Method of forming a catalyst for growing nanotubes/nanofibers and of horizontally growing nanotubes/nanofibres
Verfahren zum Bilden eines Katalysators zum Wachsen von Nanoröhrchen/Nanofasern und zum horizontalen Wachsen von Nanoröhrchen/Nanofasern

(30) Priorité: 20.12.2007 FR 0760119
(43) Date de publication de la demande: 24.06.2009
(73) Titulaire: Commissariat à l'Énergie Atomique et aux Énergies Alternatives, 75015 Paris (FR); STMicroelectronics (Grenoble) SAS, 38000 Grenoble (FR)
(72) Inventeur: Passemard, Gérard, 38850 Bilieu (FR); Maitrejean, Sylvain, 38000, GRENOBLE (FR); Ivanova-Hristova, Valentina, 38000, GRENOBLE (FR)
(74) Mandataire: Thibon, Laurent

(56) Documents cités:
- WO-A-2006/010684
- US-A1- 2005 215 049
- US-A1- 2006 086 958
- US-A1- 2006 281 298
- US-A1- 2007 205 450
- US-A1- 2007 231 946
- HOENLEIN W: "NEW PROSPECTS FOR MICROELECTRONICS: CARBON NANOTUBES" JAPANESE JOURNAL OF APPLIED PHYSICS, JAPAN SOCIETY OF APPLIED PHYSICS, TOKYO, JP, vol. 41, no. 6B, PART 01, 1 juin 2002 (2002-06-01), pages 4370-4374, XP001163432 ISSN: 0021-4922

## Description

### Domaine de l'invention

La présente invention concerne la croissance horizontale de nanotubes/nanofibres. Par croissance horizontale, on entend une croissance dans des directions sensiblement parallèles au plan d'un substrat, cette croissance se développant à partir d'un ou plusieurs flancs d'un plot ou d'une portion de couche mince.

La présente invention prévoit plus particulièrement un procédé de connectique utilisable pour réaliser des plans de connexion dans les couches supérieures d'un circuit intégré.

### Exposé de l'art antérieur

Les nanotubes/nanofibres, par exemple les nanotubes de carbone ou les nanofibres de silicium, connaissent de nombreuses applications. L'un des modes de croissance les plus courants aujourd'hui de ces nanotubes/nanofibres consiste à les faire croître à partir du fond d'une cavité cylindrique. Ce mode de croissance se prête particulièrement bien, dans le cas des nanotubes de carbone conducteurs, à la réalisation de connexions verticales entre des régions conductrices horizontales de plans de connexion d'un circuit intégré.

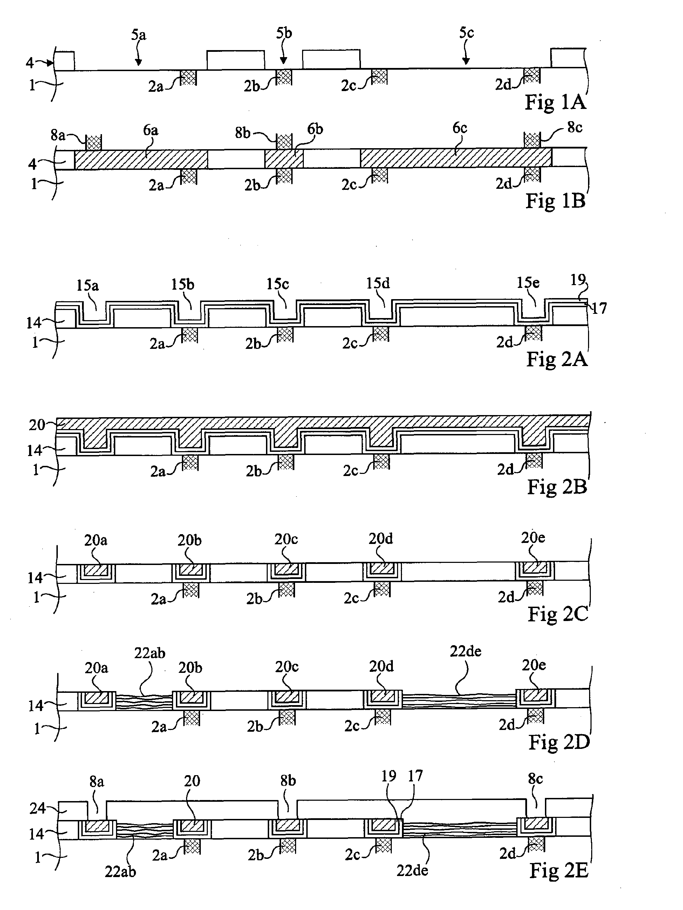

Les figures 1A et 1B illustrent des étapes de fabrication d'un niveau de connexion d'un circuit intégré par une technique dite "damascène".

Des exemples de tels conducteurs sont connus de US-2007,205,450, WO-2006,010,684, US-2005,215,049 et US-2007,231,946.

Comme l'illustre la figure 1A, on part de la surface supérieure d'une couche 1 en un matériau isolant, à certains emplacements de laquelle affleurent des vias métalliques 2a, 2b, 2c, 2d. Sur cette structure, on dépose une couche isolante 4 qui est gravée pour former des ouvertures 5a, 5b, 5c.

A l'étape illustrée en figure 1B, on a rempli les ouvertures d'un métal tel que du cuivre en déposant d'abord uniformément une couche de cuivre plus épaisse que la couche isolante 4 puis en procédant à un polissage mécano-chimique (CMP) de cette couche de cuivre pour qu'elle remplisse les ouvertures 5 ménagées dans la couche 4. On a ainsi formé des régions de cuivre 6a, 6b, 6c. Dans l'exemple représenté, la portion de couche de cuivre 6a est destinée à réaliser une connexion entre le via 2a et un via de niveau supérieur 8a éloigné en vue de dessus du via 2a. La portion de couche 6b joue simplement le rôle de plot de liaison entre un via inférieur 2b et un via supérieur 8b. La portion de couche 6c est destinée à assurer la liaison entre les vias 2c et 2d, et éventuellement avec un via de niveau supérieur 8c.

Avec la réduction des dimensions des circuits intégrés, les largeurs et les épaisseurs de pistes métalliques telles que les pistes 6a et 6c de la figure 1B tendent à se réduire. Il en résulte qu'il devient de plus en plus difficile de faire passer des courants relativement importants dans ces conducteurs sans provoquer d'échauffement excessif, voire de diffusion des métaux dans les couches adjacentes ou encore de destruction de ces conducteurs.

On a proposé de remplacer les conducteurs constitués de couches métalliques par des conducteurs constitués de structures telles que des faisceaux de nanotubes de carbone ou autres nanofibres. Toutefois, la réalisation pratique de telles structures se heurte à de nombreuses difficultés.

Ainsi, un objet d'un mode de réalisation de la présente invention est de prévoir un procédé de fabrication d'une structure de couche de connexion de circuit intégré et comprenant des nanotubes ou nanofibres de carbone s'étendant horizontalement à partir d'une paroi verticale.

### Résumé de l'invention

Ainsi, un mode de réalisation de la présente invention prévoit un procédé de formation de catalyseur de croissance de nanotubes/nanofibres sur les flancs de portions d'une couche d'un premier matériau selon la revendication 1.

Selon un mode de réalisation de la présente invention, le procédé comprend en outre, après l'élimination du deuxième matériau en regard de flancs choisis des portions du premier matériau, une étape de traitement thermique de conditionnement des régions apparentes de la couche de matériau catalytique.

Selon un mode de réalisation de la présente invention, les ouvertures dans la couche mince d'un deuxième matériau sont évasées vers le haut.

Selon un mode de réalisation de la présente invention, le dépôt de couche très mince de catalyseur est effectué de façon oblique.

Un mode de réalisation de la présente invention prévoit un procédé de réalisation d'un niveau de connexion d'un circuit intégré comprenant les étapes consistant à déposer une couche isolante ; ouvrir cette couche aux emplacements auxquels on veut établir une connexion avec un via de niveau inférieur et aux emplacements d'extrémités de pistes conductrices rectilignes ; déposer une couche de catalyseur de croissance de nanotubes/nanofibres ; remplir les ouvertures de plots conducteurs ; éliminer des portions de la couche isolante dans des régions rectilignes s'étendant entre deux surfaces en regard de plots conducteurs ; et faire croître des nanotubes/nanofibres.

Selon un mode de réalisation de la présente invention, les nanotubes/nanofibres sont des nanotubes de carbone et le catalyseur est un matériau choisi dans le groupe des matériaux de la famille du fer et de leurs oxydes ou composites.

Selon un mode de réalisation de la présente invention, la couche de catalyseur est soumise à un traitement thermique de coalescence immédiatement avant l'étape de croissance des nanotubes.

Selon un mode de réalisation de la présente invention, le matériau conducteur est du cuivre.

Selon un mode de réalisation de la présente invention, le procédé comprend en outre, après l'étape de dépôt de matériau catalytique, l'étape de dépôt d'une couche ayant une fonction de barrière/accrochage.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A et 1B, décrites précédemment, illustrent un procédé de formation de couche de connexion de circuit intégré, couramment appelé damascène ;
les figures 2A à 2E illustrent des étapes successives d'un procédé de fabrication d'une structure de connexion de circuit intégré selon un mode de réalisation de la présente invention ;
les figures 3A et 3B illustrent une variante d'étapes de mise en oeuvre d'un procédé selon la présente invention ; et
les figures 4A et 4B illustrent une autre variante d'étapes de mise en oeuvre d'un procédé selon la présente invention.

Comme cela est habituel dans la représentation des circuits intégrés, les diverses figures ne sont pas tracées à l'échelle.

### Description détaillée

Les figures 2A à 2E illustrent un exemple d'application d'un procédé selon un mode de réalisation de la présente invention. Dans cet exemple, on cherche à réaliser un niveau de connexion ayant la même fonction que le niveau de connexion décrit en relation avec les figures 1A et 1B. Ainsi, on cherche à former une première piste conductrice établissant la liaison entre un via inférieur 2a et un via supérieur 8a, un plot établissant une liaison directe entre un via inférieur 2b et un via supérieur 8b, et une connexion établissant une liaison entre un via inférieur 2c, un autre via inférieur 2d et éventuellement un via supérieur 8c.

En figure 2A, comme en figure 1A, on a représenté une couche isolante 1 à la surface supérieure de laquelle sont formés des vias 2a, 2b, 2c et 2d. On commence par déposer sur la structure une couche intermédiaire 14. La couche intermédiaire 14 est une couche isolante dans le cas de l'exemple représenté dans lequel des parties de cette couche doivent rester en place en fin de fabrication. La couche intermédiaire 14 pourra être en un matériau sacrificiel quelconque dans le cas (non représenté) où tous les éléments de cette couche seront éliminés à une étape ultérieure. Dans la couche 14 sont creusées des ouvertures 15a à 15e aux emplacements d'extrémités de pistes rectilignes, ce qui est le cas pour les ouvertures 15a-15b et 15d-15e, et aux emplacements où l'on veut former des plots conducteurs, ce qui est le cas de l'ouverture 15c.

Sur la structure comprenant la couche 14 munie des ouvertures 15a à 15e, on dépose une couche 17 d'un catalyseur de croissance de nanotubes/nanofibres et éventuellement une couche 19 de barrière à la diffusion d'une couche conductrice déposée ultérieurement. On notera qu'au lieu d'être sous forme d'une couche continue, le catalyseur peut être sous forme de particules ou d'une couche discontinue. Dans le cas où le matériau conducteur à déposer est du cuivre, le matériau de la couche 19 sera par exemple TiNx, TaNx, WC, WCN... Cette couche de matériau barrière est déposée par tout procédé connu adapté (par exemple, dépôt physique en phase vapeur, dépôt chimique en phase vapeur ou procédé électrochimique).

Comme l'illustre la figure 2B, on dépose ensuite une couche uniforme d'un matériau conducteur 20, par exemple du cuivre, mais il pourrait également s'agir d'argent, de tungstène, ou d'un alliage ou composé métallique adapté à un polissage mécano-chimique. La couche 20 est déposée sur une épaisseur suffisante pour remplir des ouvertures 15a à 15e et présenter une surface supérieure sensiblement plane.

La figure 2C représente la même structure après une étape de polissage mécano-chimique du cuivre 20. Cette étape de polissage mécano-chimique est poursuivie jusqu'à éliminer les parties horizontales supérieures de la couche barrière 19 et de la couche de catalyseur 17, de sorte que des plots de cuivre 20a à 20e restent en place dans les ouvertures 15a à 15e.

A l'étape illustrée en figure 2D on a éliminé par masquage et gravure, ou par tout autre moyen approprié, le matériau 14 aux emplacements où on désire former une piste rectiligne, c'est-à-dire entre des faces en regard des plots 20a-20b et entre des faces en regard des plots 20d-20e. Cette gravure, qui est bien entendu une gravure sélective du matériau de la couche 14 par rapport à tous les autres matériaux de la structure, dégage les faces en regard des plots 20a-20b et 20d-20e revêtues d'une couche apparente du catalyseur de croissance de nanotubes/nanofibres déposé à l'étape illustrée en figure 2A. Après cela, on procède par tout procédé connu à une croissance de nanotubes/nanofibres qui s'étendent à partir de chacune des faces en regard vers la face opposée. On obtient ainsi une liaison entre les plots par des faisceaux de nanofibres 22ab et 22de. Comme on l'a indiqué précédemment, ces faisceaux de nanotubes/nanofibres remplacent avantageusement une piste en un matériau conducteur, y compris une piste en cuivre de petites dimensions.

A l'étape illustrée en figure 2E, on a revêtu l'ensemble de la structure d'une nouvelle couche de matériau isolant 24 munie d'ouvertures au niveau des plots 20 au dessus desquels on veut former des vias 8a, 8b, 8c vers un niveau de connexion supérieur.

L'homme de l'art notera que ce qui précède ne décrit qu'un exemple d'application particulier d'un procédé selon la présente invention. Dans le cadre de cet exemple, de nombreuses variantes sont possibles en ce qui concerne les matériaux utilisés, qui doivent seulement être mutuellement compatibles, sélectivement gravables, et aptes à supporter les températures de traitement successives utilisées. D'autre part, il est également connu de l'homme du métier que diverses couches très minces intermédiaires, non décrites ni représentées, pourront être utilisées pour assurer des fonctions d'accrochage, de barrière, d'isolement, de protection, d'arrêt de gravure, etc. Egalement, chacun des matériaux décrits à titre d'exemple pourra être remplacé par un matériau ayant dans le procédé considéré et dans la structure à obtenir les mêmes fonctions.

L'invention a été décrite dans le cadre de la réalisation d'un plan de connexion au-dessus d'un circuit intégré. De façon générale, la présente invention s'applique à la réalisation de faisceaux de nanotubes/nanofibres horizontaux, s'étendant à partir de flancs de couches minces revêtus de catalyseurs de croissance de nanotubes/nanofibres. Ces faisceaux n'auront pas nécessairement un rôle de connexion mais pourront avoir d'autres fonctions, par exemple constituer des composants électroniques actifs ou passifs tels que des transistors ou des résistances. Des transistors MOS ou bipolaires pourront être réalisés à partir de nanofibres de silicium convenablement dopées. On pourra aussi chercher à former des structures ayant uniquement ou en outre un rôle mécanique pour former des microstructures électromécaniques (MEMS).

Parmi les avantages du procédé décrit, on notera que le catalyseur de croissance de nanotubes/nanofibres formé sur les flancs de portions de couches ou plots conducteurs peut être de particulièrement bonne qualité. En effet, cette portion de catalyseur vertical n'est soumise à aucune étape de masquage pour procéder à une gravure sélective (par plasma) d'autres portions de cette même couche de catalyseur. Un masquage et une attaque plasma partielle conduiraient inévitablement par les divers processus connus à affecter d'une certaine manière et/ou à polluer les parties qui ne sont pas gravées. Pour dégager ces parties verticales de catalyseur, on procède simplement, comme cela est représenté à l'étape de la figure 2D, à une gravure du matériau isolant/sacrificiel 14 en regard de ces parties verticales. On pourra choisir le matériau isolant/sacrificiel de telle manière que son élimination n'affecte en aucune manière la qualité de la couche de catalyseur.

Parmi les catalyseurs connus de croissance de nanotubes/nanofibres, on notera, pour les nanotubes de carbone des matériaux de la famille du fer (fer, nickel, cobalt) et leurs oxydes et autres composés. Ces matériaux sont généralement déposés par CVD ou par pulvérisation et éventuellement soumis à un processus de démouillage (élévation à une température proche du point de fusion pour provoquer une coalescence du matériau). Pour la croissance de nanofils de silicium, on pourra utiliser des matériaux tels que l'or, le platine, des alliages de ces matériaux, et éventuellement des siliciures de ces matériaux qui sont également déposés et éventuellement soumis à un processus de démouillage. Le procédé décrit ici se prête à séparer les étapes de dépôt et de traitement thermique des matériaux de catalyseur. Par exemple, le dépôt pourra être effectué à l'étape illustrée en figure 2A alors que le processus de coalescence pourra être mise en oeuvre seulement à l'étape illustrée en figure 2D. Ceci améliore encore la qualité du catalyseur, ce qui est un point essentiel pour permettre une croissance satisfaisante de nanotubes/nanofibres de caractéristiques désirées.

A titre d'exemple d'ordres de grandeur dimensionnels, on notera que la couche intermédiaire 14 pourra avoir une épaisseur de l'ordre de 5 nm à 200 µm, et, de préférence, dans l'application à la réalisation d'interconnexions une épaisseur comprise entre 10 et 500 nm. Par ailleurs, la couche de catalyseur 17 aura de préférence une épaisseur deux fois plus faible que celle de la couche intermédiaire 14.

La présente invention est susceptible de nombreuses autres variantes et modifications.

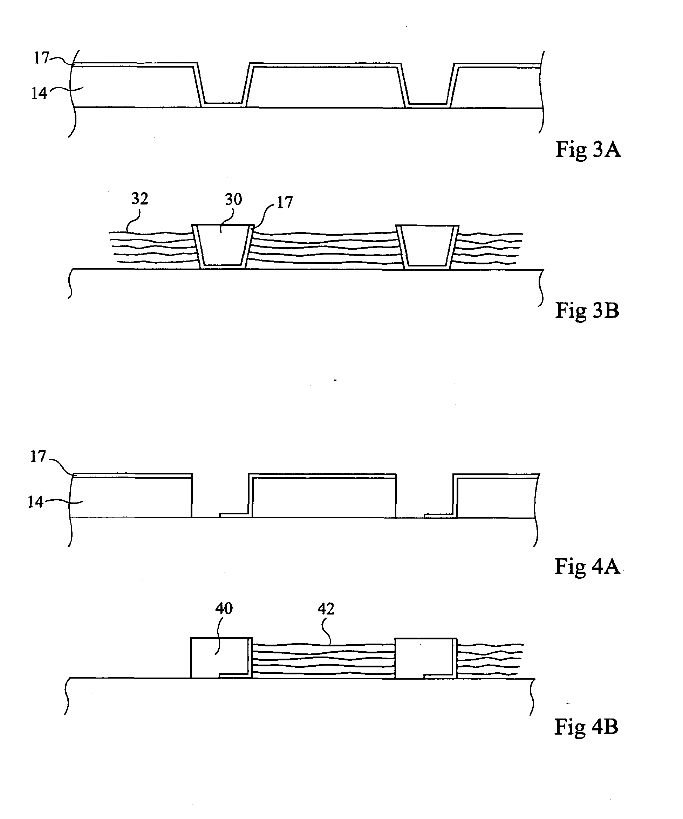

Une première variante est illustrée en figures 3A et 3B. Lors de la gravure de la couche de matériau isolant/ sacrificiel 14, on pourra choisir, comme cela est représenté en figure 3A, un processus de gravure qui permet la formation d'ouvertures à flancs évasés vers l'extérieur, ou à inclinaison positive. La figure 3B illustre le résultat obtenu après avoir réalisé la suite d'étapes correspondant à la figure 2D. On obtient alors des plots conducteurs dont les parois verticales présentent une inclinaison négative. Alors, les nanotubes/nanofibres 32 qui se développent à partir de la couche de catalyseur 17 apparaissant sur ces parois verticales ont tendance à partir plutôt vers le bas, ce qui favorise un départ en direction du flanc opposé.

Une autre variante de la présente invention est illustrée en figures 4A à 4B. En figure 4A, on a représenté la couche de matériau isolant/sacrificiel 14 munie d'ouvertures. Le dépôt de la couche de catalyseur 17 est formé par un procédé de dépôt oblique, de sorte que cette couche se forme sur un flanc seulement des ouvertures ménagées dans cette couche 14 et non sur le flanc opposé. Alors, à l'étape illustrée en figure 4B, (qui correspond à la figure 2D) des nanotubes/nanofibres 42 se développeront seulement à partir d'une face d'un plot 40 vers une face opposée non traitée d'un autre plot.

L'homme de l'art notera également qu'en ce qui concerne le procédé de formation de structures de connexion d'un circuit intégré, on a mentionné seulement la formation de connexions horizontales réalisée par des nanotubes/nanofibres. Des connexions verticales, ou vias, pourront également être réalisées par des faisceaux de nanotubes/nanofibres.

Uniquement à titre d'exemple, on notera que les couches conductrices 20, 30, 40 peuvent avoir des épaisseurs comprises entre 50 nm et quelques centaines de nm et que les faisceaux de nanotubes/nanofibres peuvent avoir des longueurs allant jusqu'à quelques centaines de µm.

A titre d'autre variante, lors de l'étape de croissance (figure 2D) on peut faire pousser des nanofils d'un matériau connu pour sa faculté à passer d'une phase amorphe à cristalline puis cristalline à amorphe sous l'effet d'un courant (ex Ge₂Te₂Sb₅, GeTe, SbTe ...) (S. Meister, H. L. Peng, K. McIlwrath et al., "Synthesis and characterization of phase-change nanowires," Nano Letters 6 (7), 1514-1517 (2006). - Se-Ho Lee, Yeonwoong Jung, and Ritesh Agarwal, "Highly scalable non-volatile and ultra-low-power phase-change nanowire memory," Nat Nano 2 (10), 626-630 (2007) ).

La structure obtenue en 2D pourra être encapsulée partiellement ou totalement de façon à maintenir l'intégrité mécanique du dispositif (figure 2E) et limiter l'évaporation du matériau à changement de phase lors des cycles d'écriture-effacement. Des couches isolantes déposées par CVD pourront être utilisées (SiO₂, HfO₂, ZRO₂, SiN...).

En fonctionnement, comme classiquement dans les mémoires à changement de phase (), des impulsions de tensions permettront de passer de l'état cristallin (faible résistance) à amorphe (forte résistance) (étape d'écriture) puis de l'état amorphe à cristallin (étape d'effacement). L'information sera lue sur le dispositif par mesure de la résistance à faible tension.

Avantages :
- sur les mémoires à changement de phase, une réduction d'échelle permet entre autres de diminuer les tensions d'écriture (Se-Ho Lee, Yeonwoong Jung, and Ritesh Agarwal, "Highly scalable non-volatile and ultra-low-power phase-change nanowire memory," Nat Nano 2 (10), 626-630 (2007)) ;
- l'utilisation de nanofils plutôt que d'étapes de gravure limite les modifications du matériau par gravure ;
- par rapport aux dispositifs publiés dans la littérature ((Se-Ho Lee, Yeonwoong Jung, and Ritesh Agarwal, "Highly scalable non-volatile and ultra-low-power phase-change nanowire memory," Nat Nano 2 (10), 626-630 (2007)), celui décrit ici ne nécessite pas de report de nanofils. Les nanofils sont auto-connectés aux électrodes.

## Revendications

1. Procédé de croissance de nanotubes/nanofibres sur les flancs de portions d'une couche d'un premier matériau, comprenant les étapes suivantes :
déposer une couche d'une première épaisseur d'un deuxième matériau (14) ;
ouvrir cette couche en certains emplacements (15) ;
déposer une couche de catalyseur (17) d'une deuxième épaisseur inférieure à la première épaisseur ;
déposer une couche (20) du premier matériau sur une épaisseur supérieure à celle de la couche du deuxième matériau ;
éliminer par polissage mécano-chimique la partie supérieure de la structure jusqu'au niveau haut de la couche du deuxième matériau ;
éliminer le deuxième matériau en regard de flancs choisis des portions de couche du premier matériau ; et
faire croître des nanotubes/nanofibres (22-ab, 22d-e).

2. Procédé selon la revendication 1, comprenant en outre, après l'élimination du deuxième matériau en regard de flancs choisis des portions du premier matériau, une étape de traitement thermique de conditionnement des régions apparentes de la couche de catalyseur.

3. Procédé selon la revendication 1, dans lequel les ouvertures dans la couche du deuxième matériau (14) sont évasées vers le haut.

4. Procédé selon la revendication 1, dans lequel le dépôt de couche de catalyseur (17) est effectué de façon oblique.

5. Procédé selon l'une quelconque des revendications 1 à 4 appliqué à la réalisation d'un niveau de connexion d'un circuit intégré dans lequel le deuxième matériau est un matériau isolant, lesdits certains emplacements sont des emplacements (15b-15e) auxquels on veut établir une connexion avec un via de niveau inférieur et des emplacements (15a-15b, 15d-15e) d'extrémités de pistes conductrices rectilignes, le premier matériau est un matériau conducteur.

6. Procédé selon la revendication 5, dans lequel les nanotubes/nanofibres sont des nanotubes de carbone et le catalyseur est un matériau choisi dans le groupe des matériaux de la famille du fer et de leurs oxydes ou composites.

7. Procédé selon la revendication 6, dans lequel la couche de catalyseur est soumise à un traitement thermique de coalescence immédiatement avant l'étape de croissance des nanotubes.

8. Procédé selon l'une quelconque des revendications 5 à 7, dans lequel le matériau conducteur est du cuivre.

9. Procédé selon l'une quelconque des revendications 5 à 7, comprenant en outre, après l'étape de dépôt de catalyseur, l'étape de dépôt d'une couche barrière (19).

## Patentansprüche

1. Ein Verfahren zum Wachstum von Nanoröhren/Nanofasern auf den Seiten von Teilen einer Schicht aus einem ersten Material, wobei die folgenden Schritte vorgesehen sind:
Abscheiden einer Schicht mit einer ersten Dicke aus einem zweiten Material (14);
Öffnen dieser Schicht an gegebenen Stellen (15);
Abscheiden einer Katalysatorschicht (17) mit einer zweiten Dicke kleiner als der ersten Dicke;
Abscheiden einer Schicht (20) des ersten Materials über einer Dicke größer als die der Schicht aus dem zweiten Material;
Eliminieren durch chemisches/mechanisches Polieren des oberen Teils der Struktur bis zu dem hohen Niveau der Schicht aus dem zweiten Material;
Eliminieren des zweiten Materials, welches auf ausgewählte Seiten der Schichtenteile des ersten Materials hinweist; und
Wachsen der Nanoröhren/Nanofasern (22a-b, 22d-e).

2. Das Verfahren nach Anspruch 1, wobei ferner Folgendes vorgesehen ist:
nach dem Eliminieren des zweiten Materials, welches auf ausgewählte Seiten der Teile des ersten Materials hinweist, ein Schritt der thermischen Verarbeitung zur Konditionierung freiliegender Zonen der katalytischen Materialschicht.

3. Das Verfahren nach Anspruch 1, wobei die Öffnungen in der Schicht aus einem zweiten Material (14) sich nach oben erweitern.

4. Das Verfahren nach Anspruch 1, wobei die Abscheidung einer Katalysatorschicht (17) schräg ausgeführt wird.

5. Das Verfahren nach einem der Ansprüche 1 bis 4, angewandt auf die Bildung eines Verbindungsniveaus einer integrierten Schaltung, wobei das zweite Material ein Isoliermaterial ist und die gegebenen Stellen, Stellen (15b-15e) sind, wo der Aufbau einer Verbindung erwünscht ist mit einer Niedrig-Niveau-Via und Endstellen (15a-15b, 15d-15e) von rechtwinkligen leitenden Bahnen, und wobei das erste Material ein leitendes Material ist.

6. Das Verfahren nach Anspruch 5, wobei die Nanoröhren/Nanofasern Kohlenstoff-Nanoröhren sind und der Katalysator ein Material ist, welches ausgewählt ist aus der Gruppe von Materialien der Familie von Eisen und ihren Oxyden oder Verbindungen.

7. Das Verfahren nach Anspruch 6, wobei die Katalysatorschicht einer thermischen Koaleszenz-Verarbeitung unmittelbar vor dem Nanorohr-Wachstumsschritt der Nanoröhren ausgesetzt wird.

8. Das Verfahren nach einem der Ansprüche 5 bis 7, wobei das leitende Material Kupfer ist.

9. Das Verfahren nach einem der Ansprüche 5 bis 7, wobei ferner vorgesehen ist, dass nach dem Abscheidungsschritt des katalytischen Materials der Abscheidungsschritt einen Barriereschicht (19) vorgesehen ist.

## Claims

1. A method for growing nanotubes/nanofibers on the sides of portions of a layer of a first material, comprising the steps of:
depositing a layer of a first thickness of a second material (14);
opening this layer at given locations (15);
depositing a catalyst layer (17) of a second thickness smaller than the first thickness;
depositing a layer (20) of the first material over a thickness greater than that of the layer of the second material;
eliminating by chem./mech. polishing the upper portion of the structure up to the high level of the layer of the second material;
eliminating the second material facing selected sides of the layer portions of the first material; and
growing nanotubes/nanofibers (22a-b, 22d-e).

2. The method of claim 1, further comprising, after elimination of the second material facing selected sides of the portions of the first material, a step of thermal processing to condition exposed regions of the catalytic material layer.

3. The method of claim 1, wherein the openings in the layer of a second material (14) are flared upwards.

4. The method of claim 1, wherein the deposition of a catalyst layer (17) is performed obliquely.

5. The method of any of claims 1 to 4 applied to the formation of a connection level of an integrated circuit wherein the second material is an insulating material, said given locations are locations (15b-15e) where a connection is desired to be established with a lower-level via and end locations (15a-15b, 15d-15e) of rectilinear conductive tracks, and wherein the first material is a conductive material.

6. The method of claim 5, wherein the nanotubes/nanofibers are carbon nanotubes and the catalyst is a material selected from the group of materials of the family of iron and of their oxides or compounds.

7. The method of claim 6, wherein the catalyst layer is submitted to a thermal coalescence processing immediately before the nanotube growth step.

8. The method of any of claims 5 to 7, wherein the conductive material is copper.

9. The method of any of claims 5 to 7, further comprising, after the catalytic material deposition step, the step of depositing a barrier layer (19).
